# EUROPEAN PATENT SPECIFICATION

(11) **EP 4 376 073 B1**
(45) Date of publication and mention of the grant of the patent: **29.07.2026**
(21) Application number: 23207841.0
(22) Date of filing: 06.11.2023
(51) Int. Cl.: G01R 15/20, G01R 33/09, H10W 90/00, G01R 33/00

(54) **SEMICONDUCTOR PACKAGE WITH CURRENT SENSING**
HALBLEITERGEHÄUSE MIT STROMMESSUNG
BOÎTIER DE SEMI-CONDUCTEUR À DÉTECTION DE COURANT

(30) Priority: 22.11.2022 US 202217992189
(43) Date of publication of application: 29.05.2024
(73) Proprietor: Infineon Technologies Austria AG, 9500 Villach (AT)
(72) Inventor: CAMUSO, Gianluca, 9500 Villach (AT); GAN, Thai Kee, 75200 Melaka Tengah (MY); GOH, Shu Hui, 84000 Muar, Taman Sungai Abong Indah (MY); RABERG, Wolfgang, 82054 Sauerlach (DE); SCHOLZ, Wolfgang, 82140 Olching (DE); SHI, Wei, 81671 München (DE); TEOH, Joo Teng, 84000 Muar, Sungai Abong (MY); GOH, Hui Wen, 75250 Cheng (MY); LIM, Chiao Eing, 84000 Muar, Parit Bakar (MY)
(74) Representative: Infineon Patent Department

(56) References cited:
- WO-A1-2021/162550
- JP-A- 2005 121 471
- JP-A- 2005 123 478
- US-A1- 2007 220 988

## Description

### TECHNICAL FIELD

The instant application relates to packaged semiconductor devices and in particular relates to packaged semiconductor devices with sensor devices.

### BACKGROUND

Many applications such as automotive and industrial applications utilize semiconductor packages to accommodate high voltage loads. These semiconductor packages can include power devices such as diodes, IGBTs (insulated gate bipolar transistors), MOSFETs (metal oxide semiconductor field effect transistors), HEMTs (high electron mobility transistors), etc. These semiconductor packages can be configured as discrete components or may be configured as power converter circuits such as single and multi-phase half-wave rectifiers, single and multi-phase full-wave rectifiers, voltage regulators, etc. It is desirable to monitor the operational state of the power devices within a discrete semiconductor package for a variety of reasons, e.g., preventing failure, improving switching behavior, etc. Current solutions for incorporating sense circuity into the package may involve making unwanted tradeoffs, such as a larger package size and/or decreased performance. It is therefore desirable to provide a semiconductor package that can monitor the operational state of the devices at minimal expense and impact on package size.

US 2007/0220988 A1 discloses a leadframe made from a metallic thin plate. A physical quantity sensor chip is mounted on a stage portion of the leadframe which has smaller area than a mounting surface of the physical quantity sensor chip. The leadframe further has a rectangular frame portion enclosing the stage portion of the leadframe and a plurality of leads extending in a direction of the stage portion from the frame portion. The physical quantity sensor chip is to be mounted by superimposing the mounting surface on the stage portion and a portion of the plurality of leads in the direction of thickness of the frame portion.

JP 2005 121471 A discloses a current sensor having a vertical type magnetic sensor and a semiconductor integrated circuit processing output signals from the vertical type magnetic sensor. The vertical type magnetic sensor is mounted on a first lead frame. Further, the semiconductor integrated circuit and the current sensor are mounted on a second lead frame. A magnetically sensitive surface of the vertical type magnetic sensor is disposed so as to be perpendicular to a mount surface of the second lead frame on which the semiconductor integrated circuit is mounted.

WO 2021/162550 A1 discloses a magnetic sensor assembly having a magnetic sensor and a leadframe. The magnetic sensor has a main sensor surface and four side surfaces. The magnetic sensor is positioned onto the lead frame with one of the four side surfaces, and the main sensor surface is oriented perpendicular to a main lead frame surface of the leadframe. A first plurality of contact pads of the magnetic sensor are connected to a subgroup of a second plurality of external bond pads of the leadframe by a conductive glue.

JP 2005 123478 A discloses that two Hall elements are fixed on a lead frame for an electromagnetic transducer in a perpendicular positional relation and electrically connected to the lead frame through a metal or a conductive resin. In addition, the pellets of the Hall elements and a semiconductor chip having an integrated circuit are fixed on the lead frame, and the internal electrodes of the pellets and the semiconductor chip are electrically connected to the lead frame through thin metallic wires.

### SUMMARY

The invention is set out in the appended claims. A semiconductor package is disclosed. According to an embodiment, the semiconductor package comprises a lead frame that comprises a die pad and a first lead extending away from the die pad, a semiconductor die mounted on the die pad, a load path connection that electrically connects a first load terminal of the semiconductor die with the first lead, and a magnetic sensor arrangement mounted directly on a region of the lead frame which forms part of the load path connection, wherein the magnetic sensor arrangement comprises a magnetic current sensor that is configured to measure a current flowing through the load path connection and an electrical isolation layer that electrically isolates the magnetic current sensor from the lead frame.

A method of producing a semiconductor package is disclosed. According to an embodiment, the method includes providing a lead frame that comprises a die pad and a first lead extending away from the die pad, mounting the semiconductor die on the die pad, providing a load path connection that electrically connects a first load terminal of the semiconductor die with the first lead, and mounting a magnetic sensor arrangement directly on a region of the lead frame which forms part of the load path connection, wherein the magnetic sensor arrangement comprises a magnetic current sensor that is configured to measure a current flowing through the load path connection and an electrical isolation layer that electrically isolates the magnetic current sensor from the lead frame.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.

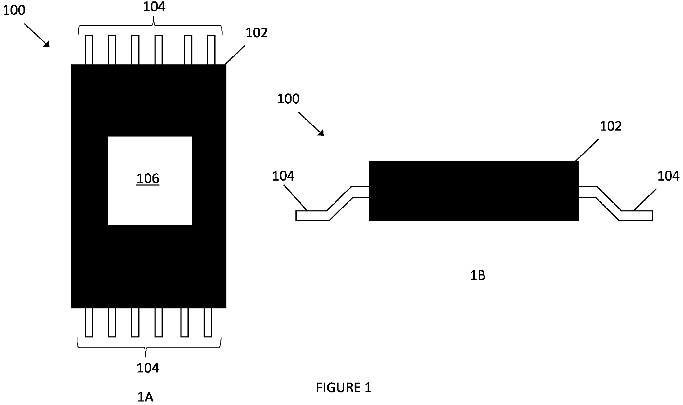

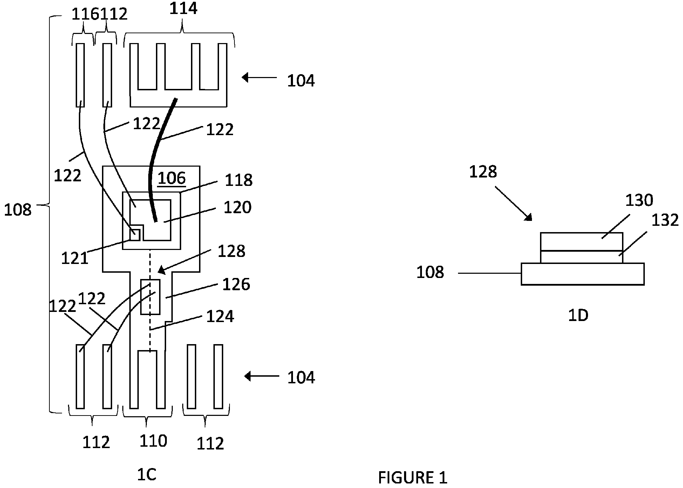

Figure 1, which includes Figs. 1A, 1B, 1C and 1D, illustrates a semiconductor package, according to an embodiment. Fig. 1A illustrates a plan-view of the semiconductor package; Fig. 1B illustrates a side-view of the semiconductor package; Fig. 1C illustrates a plan-view of an internal arrangement of the semiconductor package; and Fig. 1D illustrates a side-view of a sensor arrangement within the semiconductor package.

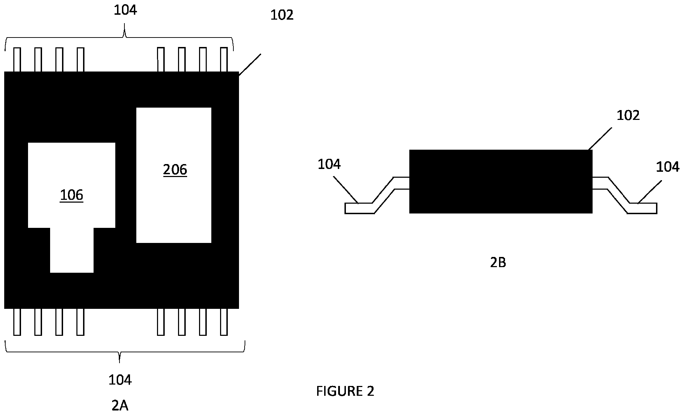

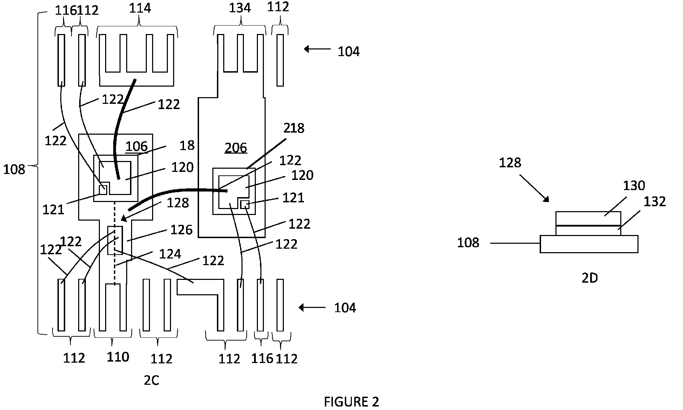

Figure 2, which includes Figs. 2A, 2B, 2C and 2D, illustrates a semiconductor package, according to an embodiment. Fig. 2A illustrates a plan-view of the semiconductor package; Fig. 2B illustrates a side-view of the semiconductor package; Fig. 2C illustrates a plan-view of an internal arrangement of the semiconductor package; and Fig. 2D illustrates a side-view of a sensor arrangement within the semiconductor package.

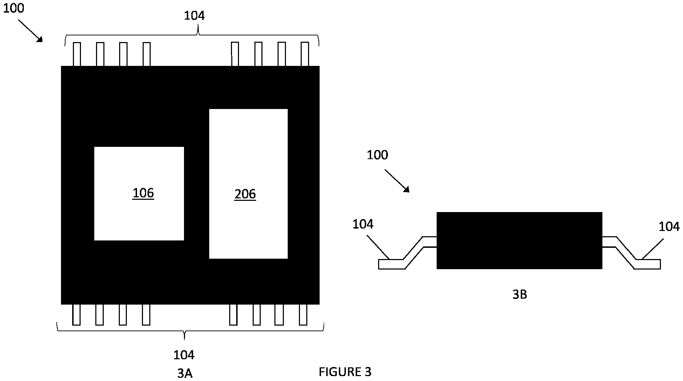

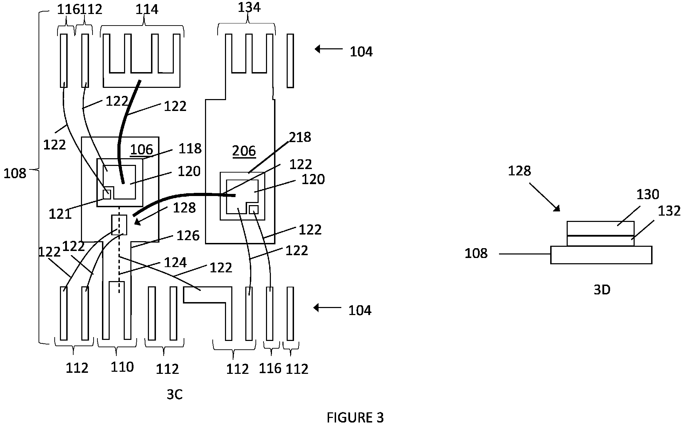

Figure 3, which includes Figs. 3A, 3B, 3C and 3D, illustrates a semiconductor package, according to an embodiment. Fig. 3A illustrates a plan-view of the semiconductor package; Fig. 3B illustrates a side-view of the semiconductor package; Fig. 3C illustrates a plan-view of an internal arrangement of the semiconductor package; and Fig. 3D illustrates a side-view of a sensor arrangement within the semiconductor package.

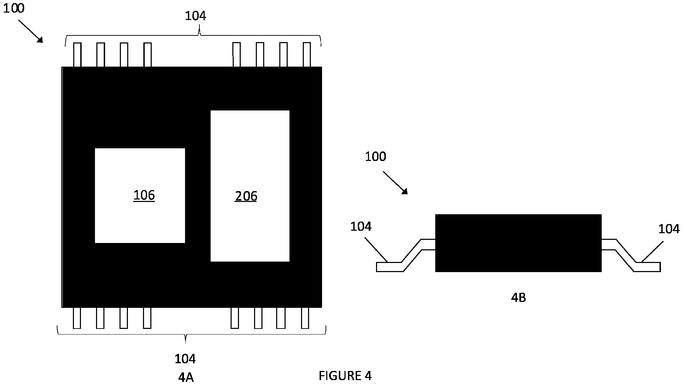

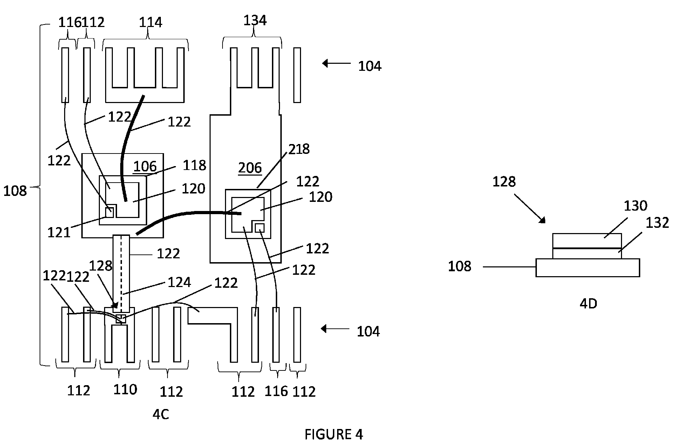

Figure 4, which includes Figs. 4A, 4B, 4C and 4D, illustrates a semiconductor package, according to an embodiment. Fig. 4A illustrates a plan-view of the semiconductor package; Fig. 4B illustrates a side-view of the semiconductor package; Fig. 4C illustrates a plan-view of an internal arrangement of the semiconductor package; and Fig. 4D illustrates a side-view of a sensor arrangement within the semiconductor package.

### DETAILED DESCRIPTION

Embodiments of a semiconductor package with an advantageous sensor arrangement and method of producing the semiconductor package are disclosed herein. The semiconductor package includes a lead frame structure with a die pad and a plurality of leads. A semiconductor die is mounted on the die pad. The semiconductor package comprises a load path connection between a first load terminal of the semiconductor die and one or more of the leads. The load path connection is provided at least in part by a section of the lead frame with a planar mounting surface. A magnetic sensor arrangement is mounted directly on this planar mounting surface. The magnetic sensor arrangement comprises a magnetic sensor that measures an electrical current flowing through the load path connection and provides the measurement signal to an independent sense lead of the semiconductor package. Because the magnetic sensor arrangement is mounted directly on the load path connection, an accurate measurement of the load current is possible. Moreover, the direct mounting of the magnetic sensor arrangement eliminates the need for a separate laterally isolated structure to accommodate a current sensor. This allows for load current sensing with minimal or no impact on package size. The magnetic sensor arrangement includes an electrical isolation layer between the lead frame and the magnetic sensor. The electrical isolation layer can be designed to withstand high voltage gradients and thus allows for sensing of a high voltage load connection.

Referring to Figs. 1A-1B, a semiconductor package 100 comprises an encapsulant body 102 with a plurality of leads 104 exposed from the encapsulant body 102. The encapsulant body 102 comprises an electrically insulating encapsulant material, e.g., mold compound, epoxy, thermosetting plastic, polymer, etc. The encapsulant body 102 may be formed by a molding technique, e.g., injection molding, compression molding, transfer molding, etc. The encapsulant body 102 is formed such that the leads 104 protrude out from outer edge sides of the encapsulant body 102 and can be mated with a carrier, such as a printed circuit board. The depicted semiconductor package 100 is configured as a so-called surface mount device, which refers to a type of package that is mounted with the leads 104 making a surface connection to the carrier. More generally, the semiconductor package 100 can have other types of package configurations such as a leadless package, through-hole, etc. The semiconductor package 100 comprises a die pad 106 that is exposed at one side of the encapsulant body 102. The die pad 106 can be mated with a heat dissipating structure such as a metal heat sink, thus allowing for efficient extraction of heat during operation. The die pad 106 can be exposed at an upper side of the encapsulant body 102 that is opposite from the surface contacting the leads 104 or from a lower side of the encapsulant body 102 that is faces the surface contacting leads 104.

Referring to Figure 1B, the semiconductor package 100 is produced from a lead frame 108 that comprises a die pad 106 and a plurality of leads 104 that extend away from the die pad 106. The leads 104 comprise a group of first leads 110 and several sensing leads 112 that extend away from a first side of the die pad 106. The leads 104 additionally comprise a group of second leads 114, a sensing lead 112, and a gate lead 116 that each extend away from a second side of the die pad 106. The lead frame 108 is formed form an electrically conductive material such as copper (Cu), Nickel (Ni), silver (Ag), palladium (Pd) gold (Au), etc., alloys or combinations thereof. The lead frame 108 can be provided from a planar sheet metal and the features of the lead frame 108 can be formed by metal processing techniques, e.g., stamping, punching, bending, etc. During processing, the leads 104 can be attached to an external peripheral ring (dambar) and detached after the encapsulant body 102 is formed and hardened.

A semiconductor die 118 is mounted on the die pad 106. According to an embodiment, the semiconductor die 118 is configured as a discrete power device that is rated to accommodate voltages of at least 100 V (volts), e.g., voltages of 600 V, 1200 V or more and/or are rated to accommodate currents of at least 1A, e.g., currents of 10A, 50A, 100A or more. These discrete power devices may include diodes, transistors, thyristors, junction field effect transistors, etc. In a particular example, the semiconductor die 118 is configured as a power transistor die, for example MOSFET (Metal Oxide Semiconductor Field Effect Transistor), IGBTs (Insulated Gate Bipolar Transistor), and HEMT (High Electron Mobility Transistor), etc.

The semiconductor die 118 comprises a first load terminal (not shown) disposed on a lower surface of the semiconductor die 118 that faces the die pad 106. The first load terminal may be electrically connected to the die pad 106 by a conductive material, e.g., solder, sinter, conductive glue, etc. The semiconductor die 118 additionally comprises a second load terminal 120 and a gate terminal 121 disposed on an upper surface of the semiconductor die 118 that faces away from the die pad 106. The second load terminal 120 of the semiconductor die 118 is electrically connected to the group of second leads 114 by an interconnect element 122. Additionally, the second load terminal 120 of the semiconductor die 118 is electrically connected to one of the sensing leads 112 by an interconnect element 122. The first terminal and the second load terminal 120 of the semiconductor die 102 correspond to the voltage blocking terminals of the device, e.g., source and drain in the case of a MOSFET, collector and emitter in the case of an IGBT, etc. The gate terminal 121 of the semiconductor die 118 is electrically connected to the gate lead 116 by one of the interconnect elements 122.

The semiconductor package 100 is configured to control a load voltage applied between the group of first leads 110 and the group of second leads 112. A fixed voltage, e.g., +600V, +1200V, etc., may be applied to the group of second leads 112 with a load being connected with the group of first leads 110. In a commonly known manner, the ON/OFF state of the semiconductor die 102 can be controlled via the gate lead 116. The sensing leads 116 are configured to provide information about an operational state of the semiconductor die 118. The sensing lead 116 connected with the second load terminal 120 can be used to determine a load voltage, while the sensing leads 116 connected with the magnetic sensor device 128 can be used to determine a load current in a manner to be described below.

The semiconductor package 100 comprises a load path connection 124 that electrically connects the first load terminal of the semiconductor die 118 with the group of first leads 110. The load path connection 124 refers to the electrically conductive structure or structures that complete the electrical connection between the first load terminal of the first semiconductor die 118 and the first leads 110. The load path connection 124 therefore conducts the output current of the semiconductor die 118 that can drive an external load connected with the group of first leads 110. The load path connection 124 comprises sections of the lead frame 108 arranged between the semiconductor die 118 and the exposed portions of the first leads 104. The load path connection 124 may optionally comprise one or more metal interconnect elements 122, e.g., metal clips, ribbons, wires, etc.

In the depicted embodiment, the die pad 106 forms part of the load path connection 124. In this case the semiconductor die 118 is configured as a vertical device with the first load terminal of the semiconductor die 118 facing and electrically connected with the die pad 106. The die pad 106 therefore conducts a load current of the semiconductor die 118.

In the depicted embodiment, the lead frame 108 comprises a sensor pad 126 that is smaller than the die pad 106 and is arranged between the die pad 106 and the group of first leads 110. The sensor pad 126 forms part of the load path connection 124. The sensor pad 126 merges with each of the leads 104 from the group of first leads 110 and merges with the die pad 106. That is, the lead frame 108 is configured to comprise a single continuous metal structure that conducts the load current from the semiconductor die 118 to the leads 104. Other configurations are possible. For example, the sensor pad 126 may be laterally spaced apart from the die pad 106 and/or the leads 104. In that case, an electrical interconnect element 122 may, e.g., metal clips, ribbon, wire, etc., may be attached between the sensor pad 126 and the die pad 106 and/or the leads 104 to complete the load path connection 124.

The semiconductor package 100 comprises a magnetic sensor arrangement 128 that is mounted on a directly on a region of the lead frame 108 which forms part of the load path connection 124. Thus, the magnetic sensor arrangement 128 is attached to a conductive structure that carries the load current. The magnetic sensor arrangement 128 comprises a magnetic current sensor 130. A magnetic current sensor 130 refers to a type of sensor device that measures the magnitude of an electrical current flowing through an electrical conductor by measuring the electromagnetic field produced by the electrical current. In contrast to other types of current sensors that perform a direct measurement of an electrical current, the indirect nature of magnetic current measurement minimizes the parasitic impact of the sensor. According to an embodiment, the magnetic current sensor 130 is a TMR (tunnel magneto-resistance) current sensor, which refers to a type of magnetic current sensor 130 with a magnetic material that changes in electrical resistance in response to a magnetic field. Other embodiments of the magnetic current sensor 130 include hall sensors, inductive sensors and anisotropic magnetoresistance (AMR) sensors, for example.

The magnetic sensor arrangement 128 is configured to measure the current flowing through the load path connection 124. As shown, the terminals of the magnetic sensor may be electrically connected to the sensing leads 112 by interconnect elements 122, thereby providing the measurement signal from the magnetic sensor at these sensing leads 112. Because the magnetic sensor arrangement 128 is mounted directly on a portion of the lead frame 108 that accommodates the load current, an accurate measurement of the load current is obtained, as the magnetic current sensor 130 is in close proximity to the magnetic field generated by the load current.

As shown in Fig. 1D, the magnetic sensor arrangement 128 comprises an electrical isolation layer 132 that electrically isolates the magnetic current sensor 130 from the lead frame 108. The electrical isolation layer 132 is configured to isolate the magnetic current sensor 130 from the electric fields associated with the load path connection 128, which may be damaging in the case of a power device. The electrical isolation layer 132 may be needed because the magnetic current sensor 130 itself may have a thin or non-existent package structure that is unable to withstand the electric fields associated with the load path connection 128. Generally speaking, the electrical isolation layer 132 can comprise any of a wide variety of electrically insulating materials, e.g., ceramic, plastic, glass, fiber glass. Moreover, the electrical isolation layer 132 can be provided in a variety of different forms, e.g., tape, glue, resin, etc. The thickness and material composition of the electrical isolation layer 132 can be selected to balance the tradeoff between required dielectric strength and accurate current measurement. According to an embodiment, the magnetic sensor arrangement 128 comprises a layer of glass that is mounted directly on the surface of the lead frame 108, e.g., using an adhesive. The layer of glass may be between 5 microns and 2 millimeters thick, for example. The magnetic current sensor 130 can be attached to the layer of glass, e.g., by an adhesive as well.

Referring to Figure 2, the semiconductor package 100 is depicted, according to another embodiment. In this embodiment, the semiconductor package 100 further comprises a second semiconductor die 218 (right side of Fig. 2C). The lead frame 108 comprises an additional section with a separate die pad 106 to accommodate the second semiconductor die 218 and corresponding groups of leads 104 connected with the second semiconductor die 218. The second semiconductor die 218 may be configured as a discrete power device and may be identical to the first semiconductor die 118 (left side of Fig. 2C). The second semiconductor die 218 comprises a first load terminal (not shown) that faces and electrically connects with a second die pad 206, which in turn is electrically connected to a group of third leads 134. As shown, this electrical connection may be provided by a continuous section of the lead frame 108. The second semiconductor die 218 comprises a second load terminal 120 that is electrically connected to the die pad 106 accommodating the first semiconductor die 118 by an electrical interconnect element 122. Additionally, the second load terminal 120 of the second semiconductor die 218 is electrically connected to one of the sensing leads 112 by an interconnect element 122.

The semiconductor package 100 shown in Figure 2 may be configured as a half-bridge circuit. A half-bridge circuit refers to one type of circuit topology that is used in a power conversion circuit, such as a DC to DC converter, DC to AC converter, etc. A half-bridge circuit comprises a high-side switch connected in series with a low-side switch. The high-side switch may correspond to the first semiconductor die 118 and the low-side switch may correspond to the second semiconductor die 218. A positive supply voltage (e.g., +600V, 1200V, etc.) can be applied to the second load terminal 120 of the first semiconductor die 118 via the group of second leads 114. A negative supply voltage or reference potential (e.g., -600V, -1200V, or 0V) can be applied to the first load terminal 120 of the second semiconductor die 218 via the group of third leads 134. The gates of the high-side switch and the low-side switch are controlled by the two gate leads 116. The sense leads 112 are used to monitor the current flowing through the high-side switch and the low-side switch. The first load terminal of the first semiconductor die 118 and the second load terminal 120 of the second semiconductor die 218 are connected together at the load path connection 124 to form the output or phase terminal of the half-bridge circuit. The magnetic sensor arrangement 128 can measure the current of the half-bridge circuit at the output or phase terminal in the above-described manner.

Referring to Figure 3, the semiconductor package 100 is depicted, according to another embodiment. The embodiment of Figure 3 is substantially similar to that of Figure 2, except that the sensor pad 126 is omitted from the lead frame 108 structure. In this case, the magnetic sensor arrangement 128 is mounted directly on a section of the die pad 106 that is between the first semiconductor die 118 and the group of first leads 110 and forms part of the load path connection 124. This arrangement may be preferred for space saving reasons. Moreover, this arrangement may facilitate a larger proportion of exposed die pad 106 area for heat sink attachment and cooling of the semiconductor package 100.

Referring to Figure 4, the semiconductor package 100 is depicted, according to another embodiment. Similar to the previously described embodiment, in this embodiment the sensor pad 126 is omitted from the lead frame 108 structure. In this case, the lead frame 108 comprises a landing pad portion that connects with the group of first leads 110 and is sufficiently large to accommodate the mounting of the magnetic sensor arrangement 128 thereon. The landing pad portion of the group of first leads 110 is spaced apart from the die pad 106. An electrical interconnect element 122 (metal clip as depicted) electrically connects the landing pad portion of the group of first leads 110 with the die pad 106. Thus, the load path connection 124 comprises a section of the die pad 106, the electrical interconnect element 122, and the landing pad portion of the group of first leads 110. The landing pad portion of the group of first leads 110 can be similar or identical in geometry as the interior landing pads connected with used to connect the other leads 104 with interconnect elements (e.g., bond wires). Thus, a space-efficient arrangement can be realized.

Although the present disclosure is not so limited, the following numbered examples demonstrate one or more aspects of the disclosure.

Example 1. A semiconductor package, comprising a lead frame that comprises a die pad and a first lead extending away from the die pad; a semiconductor die mounted on the die pad; a load path connection configured to electrically connect a first load terminal of the semiconductor die with the first lead; a magnetic sensor arrangement mounted directly on a region of the lead frame which forms part of the load path connection, and an electrical isolation layer configured to electrically isolate the magnetic current sensor from the lead frame; the semiconductor package being characterized in that the magnetic sensor arrangement comprises a magnetic current sensor that is configured to measure a current flowing through the load path connection.

Example 2. The semiconductor package of example 1, wherein the first load terminal is disposed on a lower surface of the semiconductor die that faces and electrically connects with the die pad, and wherein the die pad forms part of the load path connection.

Example 3. The semiconductor package of example 2, wherein the lead frame comprises a sensor pad that is smaller than the die pad and is arranged between the die pad and the first lead, wherein the sensor pad forms part of the load path connection, and wherein the magnetic sensor arrangement is mounted directly on the sensor pad.

Example 4. The semiconductor package of example 3, wherein the sensor pad merges with the first lead.

Example 5. The semiconductor package of example 4, wherein the sensor pad merges with the die pad.

Example 6. The semiconductor package of example 3, wherein the sensor pad is spaced apart from the die pad.

Example 7. The semiconductor package of any of the preceding examples , wherein the lead frame comprises a second lead extending away from the lead frame, and wherein the magnetic current sensor is electrically connected to the second lead.

Example 8. The semiconductor package of any of the preceding examples, wherein the magnetic current sensor is a tunnel magneto-resistance effect sensor.

Example 9. The semiconductor package of any of the preceding examples, wherein the semiconductor die is a power device that is rated to block voltages of at least 100V.

Example 10. The semiconductor package of example 9, wherein the electrical isolation layer comprises glass.

Example 11. The semiconductor package of any of the preceding examples, wherein the lead frame further comprises a second die pad that is spaced apart from the die pad, wherein the semiconductor package further comprises a second semiconductor die mounted on the second die pad, and wherein the load path connection is further configured to electrically connect a second load terminal of the second semiconductor die with the first lead.

Example 12. The semiconductor package of example 11, wherein the semiconductor package is configured as a discrete half-bridge, and wherein the first and second semiconductor dies form a high-side switch and a low-side switch, respectively, of the discrete half-bridge.

Example 13. A method of producing the semiconductor package according to any of examples 1 to 12, the method comprising: providing a lead frame that comprises a die pad and a first lead extending away from the die pad; mounting the semiconductor die on the die pad; providing a load path connection configured to electrically connect a first load terminal of the semiconductor die with the first lead; mounting a magnetic sensor arrangement directly on a region of the lead frame which forms part of the load path connection, and providing an electrical isolation layer is configured to electrically isolate the magnetic current sensor from the lead frame, the method being characterized in that the magnetic sensor arrangement comprises a magnetic current sensor that is configured to measure a current flowing through the load path connection.

Example 14. The method of example 13, wherein mounting the magnetic sensor arrangement comprises placing the electrical isolation layer directly on the region of the lead frame which forms part of the load path connection and mounting the magnetic current sensor directly on the electrical isolation layer.

Example 15. The method of example 14, wherein the electrical isolation layer comprises glass.

Example 16. The method of example 13 to 15, wherein the semiconductor die is mounted such that the first load terminal is disposed on a lower surface of the semiconductor die that faces and electrically connects with the die pad.

Example 17. The method of example 13 to 16, wherein the lead frame comprises a sensor pad that is smaller than the die pad and is arranged between the die pad and the first lead, wherein the sensor pad forms part of the load path connection, and wherein the magnetic sensor arrangement is mounted directly on the sensor pad.

Example 18. The method of example 17, wherein the sensor pad merges with the first lead and the die pad.

The semiconductor dies disclosed herein can be formed in a wide variety of device technologies that utilize a wide variety of semiconductor materials. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AllnN), indium gallium nitride (InGaN), aluminum gallium indium nitride (AlGaInN) or indium gallium arsenide phosphide (InGaAsP), etc.

The semiconductor dies disclosed herein may be configured as a vertical device, which refers to a device that conducts a load current between opposite facing main and rear surfaces of the die. Alternatively, the semiconductor die 118s may be configured as a lateral device, which refers to a device that conducts a load current parallel to a main surface of the die.

The term "interconnect element" as used herein refers to any electrically conductive structure that can be mated with two metal surfaces, e.g., bond pads, to form a stable electrical connection between these metal surfaces. Examples of interconnect elements include bond wires, ribbons, and metal clips.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

## Claims

1. A semiconductor package (100), comprising:
a lead frame (108) that comprises a die pad (106) and a first lead (110) extending away from the die pad (106);
a semiconductor die (118) mounted on the die pad (106);
a load path connection (124) configured to electrically connect a first load terminal of the semiconductor die (118) with the first lead (110);
a magnetic sensor arrangement (128) mounted directly on a region of the lead frame (108) which forms part of the load path connection (124), and
an electrical isolation layer (132) configured to electrically isolate the magnetic current sensor (130) from the lead frame (108);
the semiconductor package (100) being **characterized in that**
the magnetic sensor arrangement (128) comprises a magnetic current sensor (130) that is configured to measure a current flowing through the load path connection (124).

2. The semiconductor package (100) of claim 1, wherein the first load terminal is disposed on a lower surface of the semiconductor die (118) that faces and electrically connects with the die pad (106), and wherein the die pad (106) forms part of the load path connection (124).

3. The semiconductor package (100) of claim 2, wherein the lead frame (108) comprises a sensor pad (126) that is smaller than the die pad (106) and is arranged between the die pad (106) and the first lead (110), wherein the sensor pad (126) forms part of the load path connection (124), and wherein the magnetic sensor arrangement (128) is mounted directly on the sensor pad (126).

4. The semiconductor package (100) of claim 3, wherein the sensor pad (126) merges with the first lead (110).

5. The semiconductor package of claim 4, wherein the sensor pad (126) merges with the die pad (106).

6. The semiconductor package (100) of claim 3, wherein the sensor pad (126) is spaced apart from the die pad (106).

7. The semiconductor package (100) of any of the preceding claims, wherein the lead frame (108) comprises a second lead (112) extending away from the lead frame (108), and wherein the magnetic current sensor (130) is electrically connected to the second lead (112).

8. The semiconductor package (100) of any of the preceding claims, wherein the magnetic current sensor (130) is a tunnel magneto-resistance effect sensor.

9. The semiconductor package (100) of any of the preceding claims, wherein the semiconductor die (118) is a power device that is rated to block voltages of at least 100V.

10. The semiconductor package (100) of claim 9, wherein the electrical isolation layer (132) comprises glass.

11. The semiconductor package (100) of any of the preceding claims, wherein the lead frame (108) further comprises a second die pad (206) that is spaced apart from the die pad (106), wherein the semiconductor package further comprises a second semiconductor die (218) mounted on the second die pad (206), and wherein the load path connection (124) is further configured to electrically connect a second load terminal (120) of the second semiconductor die (218) with the first lead (110).

12. The semiconductor package (100) of claim 11, wherein the semiconductor package is configured as a discrete half-bridge, and wherein the first (118) and second semiconductor dies (218) form a high-side switch and a low-side switch, respectively, of the discrete half-bridge.

13. A method of producing the semiconductor package according to any of claims 1 to 12, the method comprising:
providing a lead frame (108) that comprises a die pad (106) and a first lead (110) extending away from the die pad (106);
mounting the semiconductor die (118) on the die pad (106);
providing a load path connection (124) configured to electrically connect a first load terminal of the semiconductor die (118) with the first lead (110);
mounting a magnetic sensor arrangement (128) directly on a region of the lead frame (108) which forms part of the load path connection (124); and
providing an electrical isolation layer (132) configured to electrically isolate the magnetic current sensor (130) from the lead frame (108),
the method being **characterized in that**
the magnetic sensor arrangement (128) comprises a magnetic current sensor (130) that is configured to measure a current flowing through the load path connection (124).

14. The method of claim 13, wherein mounting the magnetic sensor arrangement (128) comprises placing the electrical isolation layer (132) directly on the region of the lead frame (108) which forms part of the load path connection (124) and mounting the magnetic current sensor (130) directly on the electrical isolation layer (132).

15. The method of claim 14, wherein the electrical isolation layer (132) comprises glass.

16. The method of any of claims 13 to 15, wherein the semiconductor die (118) is mounted such that the first load terminal is disposed on a lower surface of the semiconductor die (118) that faces and electrically connects with the die pad (106).

17. The method of any of claims 13 to 16, wherein the lead frame (108) comprises a sensor pad (126) that is smaller than the die pad (106) and is arranged between the die pad (106) and the first lead (110), wherein the sensor pad (126) forms part of the load path connection (124), and wherein the magnetic sensor arrangement (128) is mounted directly on the sensor pad (126).

18. The method of claim 17, wherein the sensor pad (126) merges with the first lead (110) and the die pad (106).

## Patentansprüche

1. Halbleitergehäuse (100), umfassend:
einen Leiterrahmen (108), der ein Die-Pad (106) und einen ersten Leiter (110), der sich von dem Die-Pad (106) weg erstreckt, umfasst;
einen Halbleiter-Die (118), der auf dem Die-Pad (106) montiert ist;
eine Lastpfadverbindung (124), die konfiguriert ist, um einen ersten Lastanschluss des Halbleiter-Dies (118) mit dem ersten Leiter (110) elektrisch zu verbinden;
eine Magnetsensoranordnung (128), die direkt auf einem Bereich des Leiterrahmens (108) montiert ist, der einen Teil der Lastpfadverbindung (124) bildet, und
eine elektrische Isolationsschicht (132), die konfiguriert ist, um den magnetischen Stromsensor (130) von dem Leiterrahmen (108) elektrisch zu isolieren;
wobei das Halbleitergehäuse (100) **dadurch gekennzeichnet ist, dass**
die Magnetsensoranordnung (128) einen magnetischen Stromsensor (130) umfasst, der konfiguriert ist, um einen durch die Lastpfadverbindung (124) fließenden Strom zu messen.

2. Halbleitergehäuse (100) nach Anspruch 1, wobei der erste Lastanschluss auf einer unteren Oberfläche des Halbleiter-Dies (118) angeordnet ist, die dem Die-Pad (106) zugewandt ist und mit diesem elektrisch verbunden ist, und wobei das Die-Pad (106) einen Teil der Lastpfadverbindung (124) bildet.

3. Halbleitergehäuse (100) nach Anspruch 2, wobei der Leiterrahmen (108) ein Sensor-Pad (126) umfasst, das kleiner als das Die-Pad (106) ist und zwischen dem Die-Pad (106) und dem ersten Leiter (110) angeordnet ist, wobei das Sensor-Pad (126) einen Teil der Lastpfadverbindung (124) bildet, und wobei die Magnetsensoranordnung (128) direkt auf dem Sensor-Pad (126) montiert ist.

4. Halbleitergehäuse (100) nach Anspruch 3, wobei das Sensor-Pad (126) in den ersten Leiter (110) übergeht.

5. Halbleitergehäuse nach Anspruch 4, wobei das Sensor-Pad (126) in das Die-Pad (106) übergeht.

6. Halbleitergehäuse (100) nach Anspruch 3, wobei das Sensor-Pad (126) von dem Die-Pad (106) beabstandet ist.

7. Halbleitergehäuse (100) nach einem der vorhergehenden Ansprüche, wobei der Leiterrahmen (108) einen zweiten Leiter (112) umfasst, der sich von dem Leiterrahmen (108) weg erstreckt, und wobei der magnetische Stromsensor (130) mit dem zweiten Leiter (112) elektrisch verbunden ist.

8. Halbleitergehäuse (100) nach einem der vorhergehenden Ansprüche, wobei der magnetische Stromsensor (130) ein Tunnelmagnetowiderstandseffektsensor ist.

9. Halbleitergehäuse (100) nach einem der vorhergehenden Ansprüche, wobei der Halbleiter-Die (118) eine Leistungsvorrichtung ist, die bemessen ist, um Spannungen von mindestens 100 V zu blockieren.

10. Halbleitergehäuse (100) nach Anspruch 9, wobei die elektrische Isolationsschicht (132) Glas umfasst.

11. Halbleitergehäuse (100) nach einem der vorhergehenden Ansprüche, wobei der Leiterrahmen (108) ferner ein zweites Die-Pad (206) umfasst, das von dem Die-Pad (106) beabstandet ist, wobei das Halbleitergehäuse ferner einen zweiten Halbleiter-Die (218) umfasst, der auf dem zweiten Die-Pad (206) montiert ist, und wobei die Lastpfadverbindung (124) konfiguriert ist, um einen zweiten Lastanschluss (120) des zweiten Halbleiter-Dies (218) mit dem ersten Leiter (110) elektrisch zu verbinden.

12. Halbleitergehäuse (100) nach Anspruch 11, wobei das Halbleitergehäuse als eine diskrete Halbbrücke konfiguriert ist, und wobei der erste (118) und der zweite Halbleiter-Die (218) einen High-Side-Schalter bzw. einen Low-Side-Schalter der diskreten Halbbrücke bilden.

13. Verfahren zum Herstellen des Halbleitergehäuses nach einem der Ansprüche 1 bis 12, wobei das Verfahren umfasst:
Bereitstellen eines Leiterrahmens (108), der ein Die-Pad (106) und einen ersten Leiter (110), der sich von dem Die-Pad (106) weg erstreckt, umfasst;
Montieren des Halbleiter-Dies (118) auf dem Die-Pad (106);
Bereitstellen einer Lastpfadverbindung (124), die konfiguriert ist, um einen ersten Lastanschluss des Halbleiter-Dies (118) mit dem ersten Leiter (110) elektrisch zu verbinden;
Montieren einer Magnetsensoranordnung (128) direkt auf einem Bereich des Leiterrahmens (108), der einen Teil der Lastpfadverbindung (124) bildet; und
Bereitstellen einer elektrischen Isolationsschicht (132), die konfiguriert ist, um den magnetischen Stromsensor (130) von dem Leiterrahmen (108) elektrisch zu isolieren,
wobei das Verfahren **dadurch gekennzeichnet ist, dass**
die Magnetsensoranordnung (128) einen magnetischen Stromsensor (130) umfasst, der konfiguriert ist, um einen durch die Lastpfadverbindung (124) fließenden Strom zu messen.

14. Verfahren nach Anspruch 13, wobei das Montieren der Magnetsensoranordnung (128) das Platzieren der elektrischen Isolationsschicht (132) direkt auf dem Bereich des Leiterrahmens (108), der einen Teil der Lastpfadverbindung (124) bildet, und das Montieren des magnetischen Stromsensors (130) direkt auf der elektrischen Isolationsschicht (132) umfasst.

15. Verfahren nach Anspruch 14, wobei die elektrische Isolationsschicht (132) Glas umfasst.

16. Verfahren nach einem der Ansprüche 13 bis 15, wobei der Halbleiter-Die (118) so montiert ist, dass der erste Lastanschluss auf einer unteren Oberfläche des Halbleiter-Dies (118) angeordnet ist, die dem Die-Pad (106) zugewandt ist und mit diesem elektrisch verbunden ist.

17. Verfahren nach einem der Ansprüche 13 bis 16, wobei der Leiterrahmen (108) ein Sensor-Pad (126) umfasst, das kleiner als das Die-Pad (106) ist und zwischen dem Die-Pad (106) und dem ersten Leiter (110) angeordnet ist, wobei das Sensor-Pad (126) einen Teil der Lastpfadverbindung (124) bildet, und wobei die Magnetsensoranordnung (128) direkt auf dem Sensor-Pad (126) montiert ist.

18. Verfahren nach Anspruch 17, wobei das Sensor-Pad (126) in den ersten Leiter (110) und das Die-Pad (106) übergeht.

## Revendications

1. Un boîtier (100) de semiconducteur, comprenant :
une grille (108) de connexion, qui comprend une plage (106) de puce et un premier conducteur (110) partant de la plage (106) de puce ;
une puce (118) à semiconducteur monté sur la plage (106) de puce ;
une connexion (124) de chemin de charge configurée pour connecter électriquement une première borne de charge de la puce (118) à semiconducteur au premier conducteur (110) ;
un agencement (128) magnétique de capteur monté directement dans une région de la grille (108) de connexion, qui forme une partie de la connexion (124) de chemin de charge, et une couche (132) d'isolation électrique configurée pour isoler électriquement le capteur (130) magnétique de courant de la grille (108) de connexion ;
le boîtier (100) de semiconducteur étant **caractérisé en ce que**
l'agencement (128) magnétique de capteur comprend un capteur (130) magnétique de courant, qui est configuré pour mesurer un courant passant dans la connexion (124) de chemin de charge.

2. Le boîtier (100) de semiconducteur de la revendication 1, dans lequel la première borne de charge est disposée sur une surface inférieure de la puce (118) à semiconducteur, qui fait face à la plage (106) de puce et qui s'y connecte électriquement, et dans lequel la plage (106) de puce forme une partie de la connexion (124) de chemin de charge.

3. Le boîtier (100) de semiconducteur de la revendication 2, dans lequel la grille (108) de connexion comprend une plage (126) de capteur, qui est plus petite que la plage (106) de puce et qui est disposée entre la plage (106) de puce et le premier conducteur (110), dans lequel la plage (126) de capteur forme une partie de la connexion (124) de chemin de charge, et dans lequel l'agencement (128) magnétique de capteur est monté directement sur la plage (126) de capteur.

4. Le boîtier (100) de semiconducteur de la revendication 3, dans lequel la plage (126) de capteur se confond avec le premier conducteur (110).

5. Le boîtier de semiconducteur de la revendication 4, dans lequel la plage (126) de capteur se confond avec la plage (106) de puce.

6. Le boîtier (100) de semiconducteur de la revendication 3, dans lequel la plage (126) de capteur est à distance de la plage (106) de puce.

7. Le boîtier (100) de semiconducteur de l'une quelconque des revendications précédentes, dans lequel la grille (108) de connexion comprend un deuxième conducteur (112) partant de la grille (108) de connexion, et dans lequel le capteur (130) magnétique de courant est connecté électriquement au deuxième conducteur (112).

8. Le boîtier (100) de semiconducteur de l'une quelconque des revendications précédentes, dans lequel le capteur (130) magnétique de courant est un capteur à effet magnétorésistance de tunnel.

9. Le boîtier (100) de semiconducteur de l'une quelconque des revendications précédentes, dans lequel la puce (118) à semiconducteur est un dispositif de puissance conçu pour bloquer des tensions d'au moins 100 V.

10. Le boîtier (100) de semiconducteur de la revendication 9, dans lequel la couche (132) d'isolation électrique comprend du verre.

11. Le boîtier (100) de semiconducteur de l'une quelconque des revendications précédentes, dans lequel la grille (108) de connexion comprend en outre une deuxième plage (206) de puce, qui est à distance de la plage (106) de puce, dans lequel le boîtier de semiconducteur comprend en outre une deuxième puce (218) à semiconducteur montée sur la deuxième plage (206) de puce, et dans lequel la connexion (124) de chemin de charge est configurée en outre pour connecter électriquement au premier conducteur (110) une deuxième borne (120) de charge de la deuxième puce (218) à semiconducteur.

12. Le boîtier (100) de semiconducteur de la revendication 11, dans lequel le boîtier de semiconducteur est configuré sous la forme d'un demi pont discret, et dans lequel les première et deuxième puces (218) à semiconducteur forment un interrupteur de côté haut et un interrupteur de côté bas respectivement du demi pont discret.

13. Un procédé de production d'un boîtier de semiconducteur suivant l'une quelconque des revendications 1 à 12, le procédé comprenant :
se procurer une grille (108) de connexion, qui comprend une plage (106) de puce et un premier conducteur (110) partant de la plage (106) de puce ;
monter la puce (118) à semiconducteur sur la plage (106) de puce ;
prévoir une connexion (124) de chemin de charge configurée pour connecter électriquement une première borne de charge de la puce (118) à semiconducteur au premier conducteur (110) ;
monter un agencement (128) magnétique de capteur directement sur une région de la grille (108) de connexion, qui forme une partie de la connexion (124) de chemin de charge ; et
prévoir une couche (132) d'isolation électrique configurée pour isoler électriquement le capteur (130) magnétique de courant de la grille (108) de connexion,
le procédé étant **caractérisé en ce que**
l'agencement (128) magnétique de capteur comprend un capteur (130) magnétique de courant, qui est configuré pour mesurer un courant passant dans la connexion (124) de chemin de charge.

14. Le procédé de la revendication 13, dans lequel monter l'agencement (128) magnétique de capteur comprend la couche (132) d'isolation électrique directement sur la région de la grille (108) de connexion, qui forme une partie de la connexion (124) de chemin de charge, et monter le capteur (130) magnétique de courant directement sur la couche (132) d'isolation électrique.

15. Le procédé de la revendication 14, dans lequel la couche (132) d'isolation électrique comprend du verre.

16. Le procédé de l'une quelconque des revendications 13 à 15, dans lequel la puce (118) à semiconducteur est montée de manière à ce que la première borne de charge soit disposée sur une surface inférieure de la puce (118) à semiconducteur, qui fait face à la plage (106) de puce et qui s'y connecte électriquement.

17. Le procédé de l'une quelconque des revendications 13 à 16, dans lequel la grille (108) de connexion comprend une plage (126) de capteur, qui est plus petite que la plage (106) de puce et qui est disposée entre la plage (106) de puce et le premier conducteur (110), dans lequel la plage (126) de capteur forme une partie de la connexion (124) de chemin de charge, et dans lequel l'agencement (128) magnétique de capteur est monté directement sur la plage (126) de capteur.

18. Le procédé de la revendication 17, dans lequel la plage (126) de capteur se confond avec le premier conducteur (110) et la plage (106) de puce.
